# EUROPÄISCHE PATENTANMELDUNG

(11) **EP 1 818 990 A2**
(43) Veröffentlichungstag der Anmeldung: **15.08.2007**
(21) Anmeldenummer: 07002378.3
(22) Anmeldetag: 03.02.2007
(51) Int. Cl.: H01L 31/042, H01L 31/02

(54) **Solarmodul für eine Photovoltaikanlage**

(30) Priorität: 14.02.2006 DE 102006006967; 08.06.2006 DE 102006026661
(71) Anmelder: Diehl AKO Stiftung & Co. KG, 88239 Wangen (DE)
(72) Erfinder: Köhler, Claus, 88299 Leutkirch (DE); Morent, Roland, 88239 Wangen (DE)
(74) Vertreter: Diehl Patentabteilung

(57) **Zusammenfassung**

Es wird ein Solarmodul (10) für eine Photovoltaikanlage vorgeschlagen mit wenigstens einer Solarzelle. Um im Fall eines abgeschatteten oder defekten Solarmoduls die Verlustleistung des Solarmoduls zu reduzieren, ist parallel zum Solarmodul (10) ein Halbleiterschaltelement (T1) geschaltet und ferner eine Ansteuerelektronik (14) vorgesehen, die das Halbleiterschaltelement (T1) im Fall einer Stromerzeugung des Solarmoduls (10) sperrt und andernfalls zum Überbrücken des Solarmoduls (10) niederohmig schaltet.

## Beschreibung

Die vorliegende Erfindung betrifft ein Solarmodul für eine Photovoltaikanlage mit wenigstens einer Solarzelle.

Eine Photovoltaikanlage besteht üblicherweise aus einer Vielzahl von Solarmodulen, die seriell zu so genannten Strings verschaltet sind. Die Solarmodule enthalten üblicherweise mehrere Solarzellen. Der oder die Strings speisen einen Wechselrichter, der spannungs- und phasenrichtig die Energie der Solarmodule an ein Wechselstromnetz bzw. einen Verbraucher liefert.

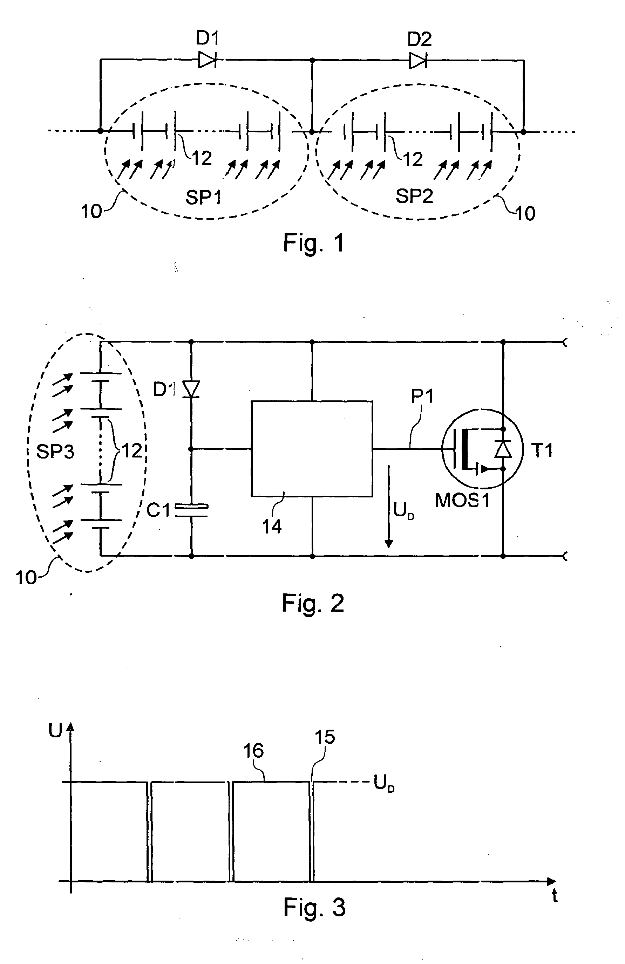

Wie in der beiliegenden Fig. 1 dargestellt, sind die Solarmodule 10 der hintereinander geschalteten Solarzellen 12 jeweils mit einer Shunt-Diode D überbrückt. Die Shunt-Diode D ist bei Sonneneinstrahlung, d.h. bei Stromerzeugung durch das Solarmodul 10 in Sperrrichtung gepolt und damit ohne Einfluss auf die Funktion des Solarmoduls. Wird ein Solarmodul in einem String vorübergehend abgeschattet, so erzeugt dieses Solarmodul 10 keine Spannung mehr und die Shunt-Diode D übernimmt den Stringstrom der übrigen Solarmodule des Strings. Das abgeschattete Solarmodul wird geschützt und die Funktionsfähigkeit des Strings bleibt erhalten. Im Fall eines defekten Solarpanels 12 funktioniert die Shunt-Diode D analog, und die Funktionsfähigkeit des übrigen Strings bleibt erhalten. Ein derartiger Aufbau eines Solarmoduls ist zum Beispiel aus der DE 88 15 963 U1 bekannt.

Bei dem in der DE 88 15 963 U1 beschriebenen Solarmodul ist den Solarmodulen außerdem ein Anzeigeelement in Form einer Leuchtdiode oder eines Drehspulinstruments parallel geschaltet, das den Stromfluss durch die Shunt-Diode anzeigt, sodass ein abgeschattetes oder defektes Solarmodul erkannt werden kann.

Die DE 20 2005 001 044 U1 offenbart eine Photovoltaikanlage mit mehreren Strings aus hintereinander geschalteten Solarmodulen, wobei jedem String eine Anzeigeeinheit nachgeschaltet ist, die mittels einer Leuchtdiode anzeigt, ob der betreffende String einen Strom liefert oder nicht.

Ein Nachteil der oben beschriebenen Solarmodule mit einer dem Solarmodul parallel geschalteten Shunt-Diode besteht darin, dass diese Shunt-Dioden im Fall eines Stromflusses eine relativ hohe Verlustleistung erzeugen. Fließt zum Beispiel ein Stringstrom von 5A durch eine solche Shunt-Diode mit einer Durchlassspannung von 1 V, so werden in der Shunt-Diode 5 W in Wärme umgesetzt. Diese Energie geht einerseits dem System verloren und kann nicht mehr in den Wechselrichter eingespeist werden; andererseits wird die Shunt-Diode heiß und erhitzt ihre Umgebung, wodurch eine benachbarte Solarzelle möglicherweise beschädigt werden kann.

Der vorliegenden Erfindung liegt daher die Aufgabe zugrunde, ein Solarmodul der eingangs genannten Art derart weiterzuentwickeln, dass seine Verlustleistung im Fall eines abgeschatteten oder defekten Solarmoduls im Vergleich zu einem herkömmlichen Solarmodul reduziert ist.

Diese Aufgabe wird gelöst durch ein Solarmodul mit den Merkmalen des Anspruchs 1. Vorteilhafte Ausgestaltungen und Weiterbildungen der Erfindung sind Gegenstand der abhängigen Ansprüche.

Das Solarmodul weist wenigstens eine Solarzelle auf. Parallel zum Solarmodul ist ein Halbleiterschaltelement geschaltet. Ferner ist eine Ansteuerelektronik vorgesehen, die das Halbleiterschaltelement im Fall einer Stromerzeugung des Solarmoduls sperrt und andernfalls zum Überbrücken des Solarmoduls niederohmig schaltet.

Durch den Ersatz der dem Solarmodul parallel geschalteten Shunt-Diode eines herkömmlichen Solarmoduls durch ein ansteuerbares Halbleiterschaltelement, das im leitenden Zustand niederohmig, insbesondere wesentlich niederohmiger als eine Shunt-Diode ist, wird eine deutlich geringere Verlustleistung des Solarmoduls im Fall eines abgeschatteten oder defekten Solarmoduls bewirkt und eine Erwärmung vermindert. Das heißt, dem Wechselrichter kann von dem Solarmodul bzw. dem String mit mehreren solcher Solarmodule mehr Energie zugeführt werden.

In einer bevorzugten Ausführungsform der Erfindung ist das Halbleiterschaltelement durch einen MOSFET-Transistor, insbesondere einen Power-MOSFET-Transistor gebildet. Die Verwendung eines MOSFET-Transistors ist besonders vorteilhaft, weil in seine Struktur eine parallele Diode integriert ist, welche als Shunt-Diode wirksam sein kann. So ist im Fall einer fehlerhaften Transistorfunktion dieses Halbleiterschaltelements möglicherweise immer noch die Funktion der Shunt-Diode vorhanden, sodass das Solarmodul funktionsfähig bleibt, wenn auch mit den Nachteilen eines herkömmlichen Solarmoduls.

In einer Ausgestaltung der Erfindung ist parallel zum Solarmodul eine Reihenschaltung aus einer Diode und einem Kondensator geschaltet, wobei der Kondensator bei Sonneneinstrahlung vom Solarmodul über die Diode aufgeladen wird und sonst die Ansteuerelektronik speist.

Die Ansteuerelektronik kann einen Multivibrator enthalten, dessen Ausgangssignal im Fall einer Stromerzeugung des Solarmoduls kurzgeschlossen ist. Alternativ kann die Ansteuerelektronik durch eine integrierte Schaltung gebildet sein.

In einer weiteren Ausgestaltung der Erfindung erzeugt die Ansteuerelektronik ein gepulstes Steuersignal mit kurzen Impulspausen, sodass das Solarmodul jeweils während des durch die kurzen Impulspausen erzeugten Zeitfensters zu seiner normalen Betriebsweise mit einem gesperrten Halbleiterschaltelement zurückkehren kann.

Obige sowie weitere Merkmale und Vorteile der Erfindung werden aus der nachfolgenden Beschreibung eines bevorzugten, nicht-einschränkenden Ausführungsbeispiels unter Bezugnahme auf die beiliegenden Zeichnungen besser verständlich. Darin zeigen:
- Fig. 1: eine vereinfachte Darstellung von zwei hintereinander geschalteten Solarmodulen gemäß dem Stand der Technik;
- Fig. 2: ein vereinfachtes Blockschaltbild eines Solarmoduls gemäß einem bevorzugten Ausführungsbeispiel der vorliegenden Erfindung;
- Fig. 3: ein Zeitdiagramm eines von der Ansteuerelektronik des Solarmoduls von Fig. 2 erzeugten Ausgangssignals;
- Fig. 4: ein Blockschaltbild des Solarmoduls von Fig. 2 mit einem detaillierteren Aufbau einer beispielhaften Ansteuerelektronik.

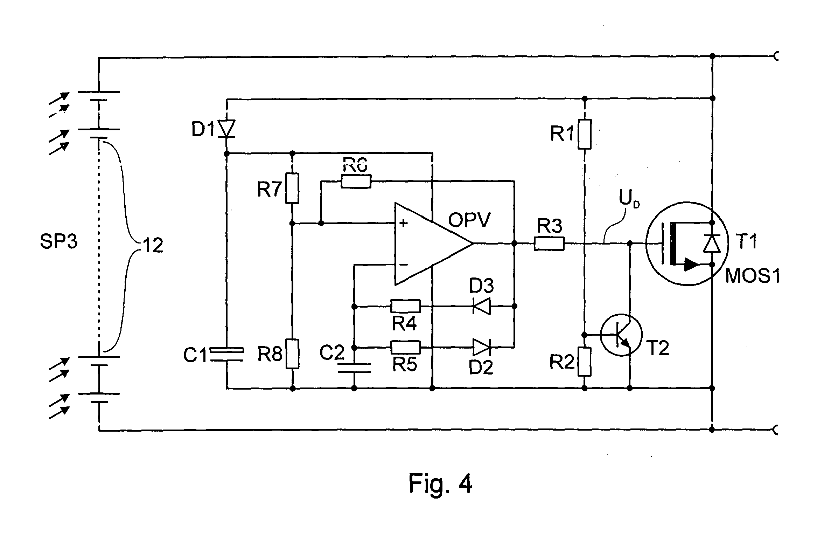

Anhand der Fig. 1 und 2 wird zunächst der grundsätzliche Aufbau und die grundsätzliche Funktionsweise eines Solarmoduls für eine Photovoltaikanlage gemäß der vorliegenden Erfindung beschrieben. Anschließend wird unter Bezugnahme auf Fig. 4 eine beispielhafte Ausführungsform einer Ansteuerelektronik eines solchen Solarmoduls näher erläutert.

Ein Solarmodul, wie es nachfolgend näher beschrieben wird, wird zum Beispiel in einer Photovoltaikanlage eingesetzt, die einen oder mehrere Strings mit mehreren hintereinander geschalteten Solarmodulen dieser Art aufweist. Die Strings speisen einen Wechselrichter, der die von den Solarmodulen erzeugte elektrische Energie spannungs- und phasenrichtig an ein Wechselstromnetz bzw. direkt an einen Verbraucher liefert.

Bezug nehmend auf Fig. 2 enthält das Solarmodul 10 mehreren Solarzellen 12, dem ein Halbleiterschaltelement T1 parallel geschaltet ist. Dieses Halbleiterschaltelement T1 ist vorzugsweise ein MOSFET-Transistor, insbesondere ein Power-MOSFET-Transistor, in dessen Struktur eine Diode integriert ist (wie in dem Ersatzschaltbild in Fig. 2 angedeutet), die als Shunt-Diode dienen kann. Selbst bei einer fehlerhaften Transistorfunktion des MOSFET-Transistors T1 kann diese Diode noch die Funktionsfähigkeit des Solarmoduls 10 analog einem herkömmlichen Solarmodul (siehe z.B. Fig. 1) gewährleisten.

Dem Halbleiterschaltelement T1 ist eine Ansteuerelektronik 14 zugeordnet. Diese Ansteuerelektronik 14 erhält ihre Versorgungsspannung von einem Kondensator C1, zum Beispiel einem Elektrolytkondensator, der dem Solarmodul 10 parallel geschaltet ist. Der Kondensator C1 wird bei Sonneneinstrahlung von dem Solarmodul 10 über eine Diode D1 aufgeladen, die hierzu dem Solarmodul 10 parallel geschaltet und in Reihe zu dem Kondensator C1 geschaltet ist, wobei die Diode D1 bei Sonneneinstrahlung in Durchlassrichtung gepolt ist. Wird das Solarmodul 10 zum Beispiel aufgrund Abschattung abgeschaltet, so gerät die Diode D1 in Sperrrichtung und koppelt den Kondensator C1 von der Spannung des Solarmoduls 10 ab.

Die Ansteuerelektronik 14 ist hochohmig für kleinsten Stromverbrauch ausgeführt. Sie erzeugt ein Ausgangssignal U_{D}, das als Steuersignal an die Steuerelektrode des Halbleiterschaltelements T1 angelegt wird und dessen zeitlicher Verlauf in Fig. 3 dargestellt ist. Während einer Stromerzeugung durch das Solarmodul 10 wird das Spannungsmuster der Ansteuerelektronik 14 allerdings unterdrückt, d.h. U_{D} = 0 V, sodass das Halbleiterschaltelement T1 gesperrt bleibt.

Bei einem abgeschatteten oder defekten Solarmodul 10 wird das in Fig. 3 beispielhaft dargestellte Spannungsmuster an das Halbleiterschaltelement T1 angelegt. Das Spannungsmuster U_{D} enthält insbesondere periodische Steuerimpulse mit kurzen Impulspausen 15 dazwischen. Während der Impulsdauern 16 wird das Halbleiterschaltelement T1 in den leitenden Zustand gesetzt, sodass das Solarmodul 10 für mindestens eine Impulsdauer überbrückt wird. Der leitende Zustand des Halbleiterschaltelements T1 ist dabei wesentlich niederohmiger als der einer herkömmlicherweise eingesetzten Shunt-Diode D (siehe Fig. 1). Während der kurzen Impulspausen übernimmt die im Halbleiterschaltelement T1 integrierte (Shunt-)Diode den Stringstrom. Wird das Solarmodul 10 wieder angestrahlt und erzeugt Strom, so werden die von der Ansteuerelektronik 14 erzeugten Steuerimpulse beginnend in einer Impulspause wieder unterdrückt, sodass das Solarmodul 10 wieder zu seiner normalen Funktion zurückehren kann. Falls das Solarmodul 10 defekt ist, bleibt das Halbleiterschaltelement T1 fortlaufend von der Ansteuerelektronik 14 mit dem in Fig. 2 veranschaulichten Ausgangssignal U_{D} angesteuert.

Die Ansteuerelektronik 14 kann zum Beispiel einen Multivibrator enthalten, wie beispielhaft in Fig. 4 dargestellt, oder als eine integrierte Schaltung ausgebildet sein.

Bezug nehmend auf Fig. 4 enthält die Ansteuerelektronik 14 insbesondere einen als astabilen Multivibrator geschalteten Operationsverstärker OP, dessen Betriebsspannung von dem vorgenannten Kondensator C1 zur Verfügung gestellt wird. Das Ausgangssignal U_{D} des Operationsverstärkers OP wird dem Gate-Anschluss des MOSFET-Transistor T1 über einen Widerstand R3 zugeführt. Der positive Eingang des Operationsverstärkers OP ist mit einem Mittelabgriff eines aus zwei Widerständen R7 und R8 gebildeten Spannungsteilers verbunden, der parallel zum Kondensator C1 geschaltet ist, und der Ausgang des Operationsverstärkers OP ist über einen Widerstand R6 auf seinen positiven Eingang rückgekoppelt.

Der negative Eingang des Operationsverstärkers OP ist über einen Kondensator C2 mit dem Basispotential seiner Betriebsspannung verbunden. Der Ausgang des Operationsverstärkers OP ist ferner über eine Parallelschaltung aus einerseits einer ersten Reihenschaltung einer in Durchlassrichtung gepolten Diode D2 und einem Widerstand R5 und andererseits einer zweiten Reihenschaltung aus einer in Sperrrichtung gepolten Diode D3 und einem Widerstand R4 auf seinen negativen Eingang rückgekoppelt.

Die wie oben beschrieben aufgebaute Ansteuerelektronik 14 erzeugt am Ausgang des Operationsverstärkers OP das in Fig. 3 veranschaulichte Spannungsmuster U_{D}, das an das Halbleiterschaltelement T1 wie oben erläutert angelegt wird. Die Dauer der Steuerimpulse und die Dauer der Impulspausen des Spannungsmusters U_{D} können über die Dioden D2 und D3 und die Widerstände R4 und R5 unabhängig voneinander eingestellt werden.

Wählt man als Schwingungsfrequenz des Multivibrators zum Beispiel 0,1 Hz, so könnte beispielsweise die Dauer der Steuerimpulse zu 9,9 Sekunden und die Dauer der Impulspausen zu 0,1 Sekunden gewählt werden. Damit würde sich nach einer Abschattung des Solarmoduls 10 alle zehn Sekunden ein Zeitfenster von 0,1 Sekunden ergeben, in dem das Solarmodul 10 wieder zu seiner normalen Funktion im String zurückkehren kann.

Während einer Stromerzeugung durch das Solarmodul 10 wird das Ausgangssignal U_{D} des Operationsverstärkers OP unterdrückt, damit der MOSFET-Transistor T1 gesperrt bleibt. Dies wird durch die folgende Schaltung erreicht.

Die Ansteuerelektronik 14 enthält ferner einen Transistor T2, dessen Kollektor mit dem Ausgang des Operationsverstärkers OP bzw. dem Gate-Anschluss des MOSFET-Transistors T1 verbunden ist und dessen Emitter mit dem Basispotential der Betriebsspannung des Operationsverstärkers OP verbunden ist. Die Basis des Transistors T2 ist mit dem Mittelabgriff eines Spannungsteilers verbunden, der aus zwei Widerständen R1 und R2 gebildet ist, die parallel zum Halbleiterschaltelement T1 geschaltet sind.

Während das Solarmodul 10 Strom erzeugt, d.h. weder abgeschattet noch defekt ist, ist der Transistor T2 über den Spannungsteiler aus R1 und R2 leitend geschaltet. Damit liegt der Gate-Anschluss des MOSFET-Transistors T1 auf seinem Source-Potential, sodass der MOSFET-Transistor T1 sperrt. In diesem Betriebszustand sperrt ferner die Diode des MOSFET-Transistors T1 und der Kondensator C1 wird über die Diode D1 aufgeladen.

Ist das Solarmodul 10 zum Beispiel abgeschattet und erzeugt keinen Strom, so sperrt der Transistor T2, sodass das Ausgangssignal U_{D} des Operationsverstärkers OP am Gate-Anschluss des MOSFET-Transistors T1 anliegt. Wie oben beschrieben ist in diesem Betriebszustand der MOSFET-Transistor T1 während der Steuerimpulse niederohmig leitend und während der Impulspausen über die integrierte Diode leitend.

## Patentansprüche

1. Solarmodul (10) mit wenigstens einer Solarzelle (12),
**dadurch gekennzeichnet,**
**dass** parallel zum Solarmodul (10) ein Halbleiterschaltelement (T1) geschaltet ist; und
**dass** ferner eine Ansteuerelektronik (14) vorgesehen ist, die das Halbleiterschaltelement (T1) im Fall einer Stromerzeugung des Solarmoduls (10) sperrt und andernfalls zum Überbrücken des Solarmoduls (10) niederohmig schaltet.

2. Solarmodul nach Anspruch 1,
**dadurch gekennzeichnet,**
**dass** das Halbleiterschaltelement (T1) durch einen MOSFET-Transistor gebildet ist.

3. Solarmodul nach Anspruch 1 oder 2,
**dadurch gekennzeichnet,**
**dass** parallel zum Solarmodul (10) eine Reihenschaltung aus einer Diode (D1) und einem Kondensator (C1) geschaltet ist, wobei der Kondensator (C1) im Fall einer Stromerzeugung des Solarmoduls (10) vom Solarmodul (10) über die Diode (D1) aufgeladen wird und sonst die Ansteuerelektronik (14) speist.

4. Solarmodul nach einem der Ansprüche 1 bis 3,
**dadurch gekennzeichnet,**
**dass** die Ansteuerelektronik (14) einen Multivibrator enthält, dessen Ausgangssignal (U_{D}) im Fall einer Stromerzeugung des Solarmoduls (10) kurzgeschlossen ist.

5. Solarmodul nach einem der Ansprüche 1 bis 3,
**dadurch gekennzeichnet,**
**dass** die Ansteuerelektronik (14) eine integrierte Schaltung enthält.

6. Solarmodul nach einem der vorhergehenden Ansprüche,
**dadurch gekennzeichnet,**
**dass** die Ansteuerelektronik (14) ein gepulstes Steuersignal mit kurzen Impulspausen erzeugt.

7. Photovoltaikanlage, mit wenigstens einem String aus mehreren in Reihe geschalteten Solarmoduln (10) nach einem der vorhergehenden Ansprüche.
